# FASCICULE DE BREVET EUROPEEN

(11) **EP 0 522 907 B1**
(45) Date de publication et mention de la délivrance du brevet: **14.08.1996**
(21) Numéro de dépôt: 92401735.3
(22) Date de dépôt: 22.06.1992
(51) Int. Cl.: G01R 31/02

(54) **Contrôle d'un vitrage chauffant**
Kontrolle einer beheizten Scheibe
Control of a heated window

(30) Priorité: 22.06.1991 DE 4120653
(43) Date de publication de la demande: 13.01.1993
(73) Titulaire: SAINT-GOBAIN VITRAGE, F-92400 Courbevoie (FR); VEGLA Vereinigte Glaswerke GmbH, D-52066 Aachen (DE)
(72) Inventeur: Sprenger, Christoph, W-5100 Aachen (DE); Esser, Hans-Georg, W-5100 Aachen (DE)
(74) Mandataire: Le Vaguerèse, Sylvain Jacques

(56) Documents cités:
- DE-A- 2 411 838
- DE-B- 1 807 643
- FR-A- 2 545 611
- US-A- 3 725 779

## Description

L'invention a trait à un procédé de vérification des conducteurs chauffants sur un vitrage pourvu de deux collecteurs que relient ces conducteurs, par création d'un courant alternatif dans ce réseau et détection inductive du champ électromagnétique qui se forme alors autour d'eux, à l'aide de têtes à capteurs magnétiques dont le signal de sortie commande un circuit d'évaluation.

On fabrique en grande série des vitrages à chauffage électrique en imprimant à l'écran de soie conducteurs et collecteurs à la surface de chaque volume, par emploi d'un émail à l'argent métallique, dont bombage ou trempe du volume provoquent ensuite la cuisson. En règle générale la largeur des conducteurs chauffants est seulement de l'ordre de 0,5 mm, de sorte qu'ils peuvent présenter des coupures à l'impression comme dans la suite de la fabrication ; il est donc indiqué de contrôler chacun d'eux lors du processus et/ou à sa sortie.

Selon un procédé connu (DE-PS-18 07 643), on applique une tension alternative sur les deux collecteurs en y branchant des câbles reliés à la source sous tension. Le champ magnétique qui se forme ainsi autour des conducteurs chauffants est alors mesuré au moyen d'une tête de lecture déplacée transversalement au dessus du réseau ; si un conducteur ne produit pas de signal, on détermine et répare sa zone de coupure. Ce procédé fonctionne correctement.

Selon un autre procédé connu de contrôle du réseau chauffant déposé à la surface d'une feuille de verre (DE-C-24 11 838), on applique un palpeur sur chaque conducteur et on compare les résistances électriques partielles du réseau des deux cotés de ce palpeur. Ce procédé requiert donc un contact de palpeur sur chacun des conducteurs.

Connaissant encore (US-A-4 610 710) un procédé de contrôle des conducteurs d'un vitrage chauffant dans lequel on relie les collecteurs à une source de courant continu et mesure le champ magnétique engendré autour des conducteurs à l'aide d'un capteur à effet Hall, l'invention a pour objet un procédé du type indiqué en tête, qui n'exige aucune jonction mécanique du circuit de mesure et se prête ainsi particulièrement bien à l'automatisation.

Selon l'invention, où s'effectuent inductivement à la fois le couplage du réseau à une source alternative et la détection, on parvient au résultat cherché en compensant la fraction de la tension de sortie des capteurs des têtes magnétiques de détection qui correspond au champ de fuite de la bobine excitatrice par une mesure séparée de ce champ de fuite effectuée au voisinage de la première entre les conducteurs chauffants, utilisant la différence des tensions fournies par les deux mesures en tant que tension de commande du circuit d'évaluation.

L'alimentation inductive des conducteurs chauffants en courant a pour avantage de supprimer tout contact avec les collecteurs, facilitant ainsi beaucoup l'automatisation du procédé et son intégration dans une ligne de fabrication. Lorsque le réseau n'est pas encore cuit, elle évite en outre les détériorations de collecteurs que ces contacts pouvaient parfois provoquer.

Il est pourtant apparu que le champ de fuite de la bobine excitatrice, inévitable, perturbait la mesure du champ relativement faible engendré autour des conducteurs, au point d'empêcher en partie celle-ci, en particulier au voisinage de l'inducteur.

L'intensité de ce champ varie d'un emplacement de mesure à l'autre, dépendant entre autres de l'éloignement à l'inducteur et, selon l'invention, on neutralise l'effet qu'il a sur la mesure en le détectant séparément dans deux zones voisines pour n'utiliser comme tension de signal que la différence des tensions engendrées.

Selon un développement intéressant du procédé selon l'invention, on emploie pour engendrer le courant à mesurer dans les conducteurs un inducteur constitué d'une bobine excitatrice à armature de haute perméabilité. Un choix convenable du matériau magnétique et un dessin approprié de cette armature réduisent le champ de fuites, améliorant le rapport signal-bruit. On atteint une amélioration supplémentaire en canalisant le champ par mise en place d'une culasse ferromagnétique sur la face arrière du vitrage.

Le choix de la fréquence d'alimentation a aussi une grande importance. Certes le courant engendré dans les conducteurs est directement proportionnel à la fréquence du champ magnétisant, de sorte qu'il faudrait ainsi employer une fréquence aussi haute que possible. Mais inductivité et capacité des capteurs équipant les têtes détectrices jouent aussi un rôle déterminant et les meilleurs résultats sont obtenus quand la fréquence du courant d'alimentation correspond à la fréquence de résonance de l'ensemble du système. Il a été constaté qu'en utilisant des têtes détectrices telles que celles employées sur les appareils d'audition à bandes ou cassettes, on obtenait un bon résultat en faisant travailler le système à une fréquence allant de 3 000 à 6 000 Hz, l'optimum étant atteint dans une plage de 3 400 à 4 000 Hz.

Selon un développement particulièrement avantageux du procédé de l'invention, le courant à mesurer n'est pas engendré directement, ensemble ou séparément, sur chacun des conducteurs chauffants mais sur l'un des deux collecteurs ; ceci non seulement augmente la distance entre les capteurs des têtes détectrices et l'inducteur source de perturbation, mais encore uniformise le courant qui circule dans le réseau. Lors de la mesure, il est alors particulièrement opportun de dimensionner et placer l'inducteur de façon qu'il couvre au moins sur le collecteur un espace séparant deux conducteurs chauffants.

La description d'un dispositif propre à la mise en oeuvre du procédé fera ressortir d'autres caractéristiques et avantages de l'invention. Elle est donnée ci dessous en liaison avec les dessins, qui montrent :
- figure 1 : en représentation partielle et schématique, un dispositif apte à la mise en oeuvre du procédé,
- figure 2 : un schéma par blocs du circuit électronique de contrôle.

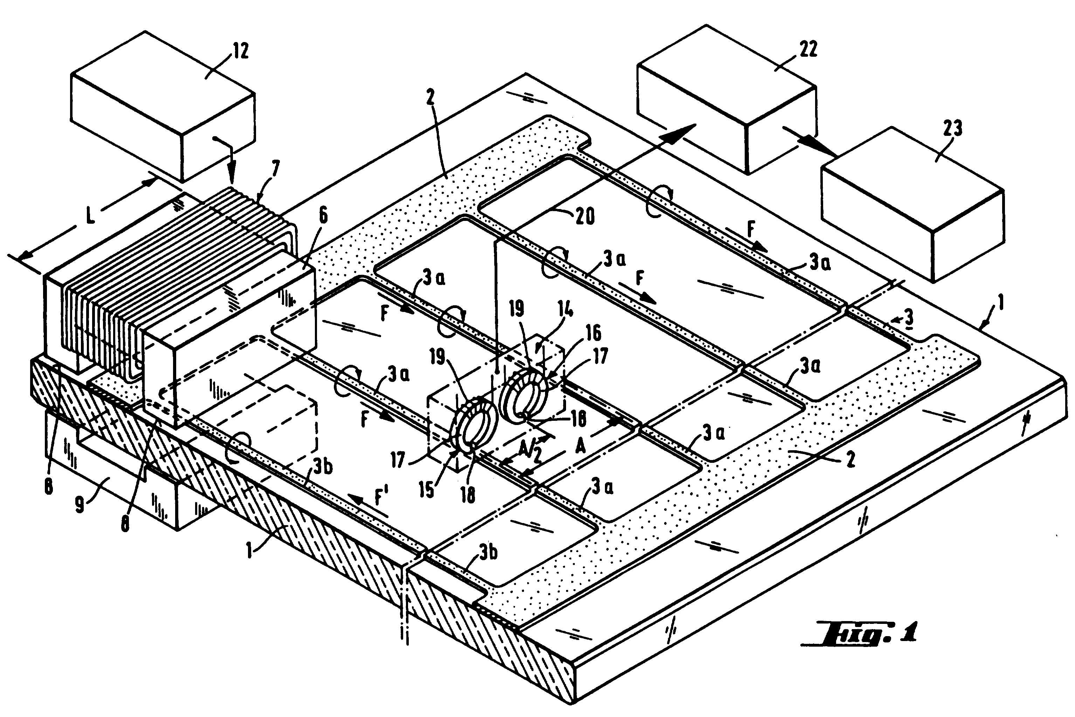

Selon la vue de la figure 1, l'une des faces d'une feuille de verre 1 reçoit un réseau constitué de collecteurs 2 et de conducteurs chauffants 3, qui partent de ces derniers. Ce réseau est imprimé sur le verre à l'écran de soie, puis la pâte électroconductrice ainsi déposée est séchée par chauffage. Au séchage succède, le cas échéant après empilage des feuilles imprimées, un traitement thermique portant le verre à une température de l'ordre de 650 °C, à laquelle la pâte se céramise à sa surface. Suit en règle générale une étape de bombage au cours de laquelle un outillage approprié bombe les volumes à la forme désirée, puis un refroidissement brusque par des organes de soufflage appropriés trempe ces volumes, leur conférant les propriétés des vitrages de sécurité.

Un contrôle du réseau, en particulier des conducteurs 3, est utile aussi bien avant sa cuisson c'est-à-dire après impression, à la suite du séchage, qu'à l'issue de l'ensemble de la fabrication. Le premier contrôle permet de réparer facilement les coupures détectées puis de réintégrer les volumes en cause dans le processus ; le contrôle final permet de détecter les défauts et détériorations apparus au cours de la suite de la fabrication.

Alors qu'après impression et séchage les volumes sont encore plans, ils possèdent lors du contrôle final leur forme définitive. Le procédé selon l'invention s'applique avec un même intérêt à un cas comme à l'autre.

Le courant à mesurer est engendré dans le réseau chauffant 2/3 par un inducteur formé d'un noyau 6, en U, autour duquel est bobiné un enroulement 7. La bobine inductrice 6/7 est placée au dessus de la face du volume porteuse de ce réseau, enjambant l'un des deux collecteurs 2, les spires de l'enroulement 7 parallèles à ce collecteur. Les faces frontales 8 du noyau 6 sont placées aussi près que possible de la feuille de verre. Pour éviter de détériorer le réseau, elles peuvent par exemple porter une couche de matériau élastique et être appliquées directement sur la surface du verre. pour augmenter le flux et réduire les fuites, il est utile en outre de placer une culasse ferromagnétique 9 en regard du noyau 6, sur l'autre face de la feuille de verre, également au plus près ; ceci ne supprime cependant pas entièrement le champ perturbateur car la présence de cette feuille entre les deux pièces 6 et 9 crée un entrefer notable. Pour obtenir un flux magnétique aussi élevé et concentré que possible donc un courant induit maximal, il convient de constituer l'armature d'un matériau ferromagnétique de haute perméabilité.

On obtient de bons résultats si la longueur L de l'inducteur 6/7/9 est supérieure à la distance A entre deux conducteurs 3 mais inférieure au double de celle-ci et qu'il coiffe le collecteur 2 de façon à couvrir deux conducteurs voisins. Il s'établit dans le réseau un courant circulant dans un sens (flèche F) d'un côté de l'inducteur, dans les conducteurs 3a, mais en sens contraire (flèche F′) de l'autre côté, dans les conducteurs 3b. Avantageusement, l'inducteur est placé sensiblement dans la zone médiane du collecteur 2, pour que le dispositif affecte semblablement les conducteurs 3a et 3b.

L'enroulement 7 est alimenté par un générateur 12 engendrant un courant alternatif d'une fréquence de 3 600 à 3 800 Hz ; la fréquence idéale correspond à la fréquence de résonance de l'ensemble du système et sera au besoin ajustée à chaque cas particulier.

La tête détectrice 14 porte, comme le montre la figure, deux capteurs magnétiques 15 et 16 comprenant chacun un noyau ferromagnétique 17 pourvu d'une fente 18 et d'un bobinage 19. Ces deux capteurs sont placés côte à côte, les plans moyens de leurs noyaux étant transversaux aux conducteurs chauffants 3, la distance séparant leurs deux fentes 18 correspondant à la moitié de l'écart entre ces derniers, soit A/2. Ainsi, dans la position de la tête 14 que montre la figure, le premier des deux capteurs 15 et 16 recueille au dessus d'un conducteur 3 le maximum de son champ secondaire, alors qu'aux champs accessoires près, le champ recueilli par le second, placé juste à mi-distance de deux de ces conducteurs 3, correspond essentiellement au champ de fuite de l'inducteur 6/7/9 ; or on peut considérer comme identique le champ perturbateur qui règne aussi dans la zone de mesure du capteur 15. La ligne 20 transmet les signaux recueillis par la tête 14 au circuit d'évaluation 22 qui agit sur un circuit de commande 23.

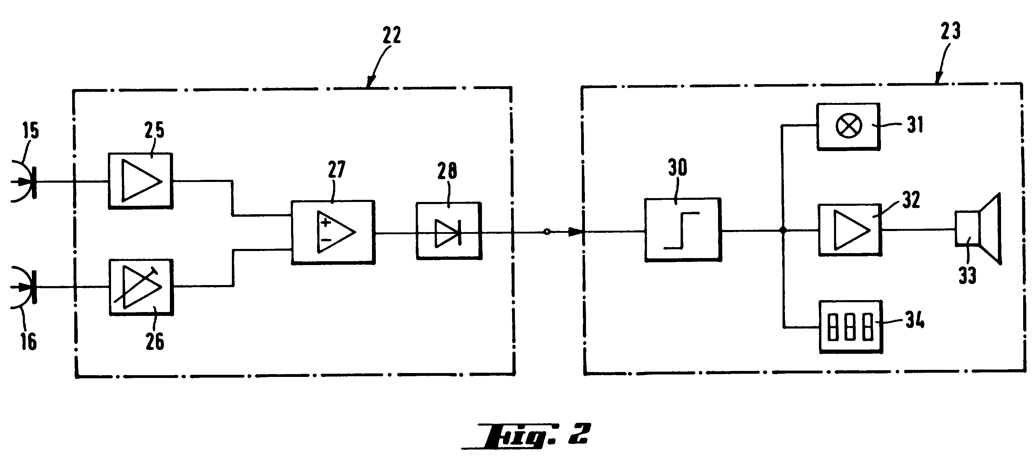

La figure 2 montre la structure des circuits 22 et 23, qui sont constitués d'éléments du commerce.

Le circuit 22 comprend essentiellement un amplificateur 25 alimenté par le capteur 15, un amplificateur 26 alimenté par le capteur 16 et un amplificateur différentiel 27. Relié à chacun des amplificateurs 25 et 26, ce dernier forme la différence des deux signaux qu'ils délivrent et l'amplifie à une valeur suffisante pour agir sur l'unité de commande 23 après traversée du redresseur 28.

Dans le cas représenté, l'unité de commande 23 comprend essentiellement un détecteur à seuil 30 qui répond quand le niveau de signal délivré par le circuit évaluateur 22 signale l'interruption d'un conducteur chauffant 3, ainsi qu'un afficheur optique 31, une alarme sonore formée d'un amplificateur 32 alimentant un haut-parleur 33 et un groupe de comptage 34 décomptant par exemple le nombre des vitrages contrôlés, avec ceux des conducteurs intacts et/ou détériorés.

Les dispositifs selon l'invention peuvent être mis en oeuvre de façons diverses. Dans leur forme la plus simple ils ne comportent qu'une tête détectrice 14, déplacée transversalement au dessus du vitrage pour vérifier un à un les conducteurs 3. Pour ce faire, on peut laisser la feuille de verre fixe au poste de contrôle et déplacer la tête 14 ou laisser fixes aussi bien l'inducteur 6/7/9 que la tête 14 et faire passer la feuille à travers ce dispositif. D'autre part, on peut aussi disposer côte à côte une rangée de têtes détectrices, par exemple en nombre correspondant à celui de l'ensemble des conducteurs 3 pour effectuer simultanément contrôle et affichage de l'état de ces derniers.

## Revendications

1. Procédé de vérification des conducteurs chauffants sur un vitrage pourvu de deux collecteurs (2) que relient ces conducteurs (3) chauffants, par création d'un courant alternatif dans ce réseau et détection inductive du champ électromagnétique qui se forme alors autour d'eux à l'aide de têtes de lecture (14) dont le signal de sortie commande un circuit d'évaluation, caractérisé en ce que, couplant inductivement le réseau à l'alimentation alternative, on compense la fraction de la tension de sortie des capteurs magnétiques qui correspond au champ de fuite de la bobine excitatrice par une mesure séparée de ce champ de fuite effectuée au voisinage de la première entre les conducteurs chauffants, utilisant la différence des tensions fournies par les deux mesures en tant que tension de commande du circuit d'évaluation.

2. Procédé selon la revendication 1, caractérisé en ce que, pour recueillir le champ magnétique engendre autour des conducteurs (3) et le champ de fuite existant entre eux, on utilise deux capteurs identiques.

3. Procédé selon l'une des revendications 1 et 2, caractérisé en ce que le courant à mesurer est engendré sur l'un des deux collecteurs (2).

4. Procédé selon la revendication 3, caractérisé en ce qu'on utilise pour créer le courant à mesurer une bobine excitatrice de longueur (L) telle qu'elle couvre deux conducteurs voisins.

5. Procédé selon l'une des revendications 3 et 4, caractérisé en ce que le courant à mesurer est engendré au moyen d'un inducteur (6,7) placé dans la zone médiane du collecteur.

6. Procédé selon l'une des revendications 1 à 5, caractérisé en ce qu'on utilise une bobine excitatrice d'armature comprenant un noyau (6) en U et, en regard de ses deux pôles, sur la face arrière du vitrage, une culasse ferromagnétique.

7. Procédé selon l'une des revendications 1 à 6, caractérisé en ce qu'on utilise une fréquence d'alimentation correspondant à la fréquence de résonance de l'ensemble du système de détection.

8. Procédé selon la revendication 7, caractérisé en ce qu'on utilise une fréquence allant de 3 400 à 4 000 Hz.

9. Dispositif pour la mise en oeuvre du procédé selon la revendication 1, comprenant un inducteur à armature (6) et enroulement (7) et une tête détectrice (14) portant côte à côte deux capteurs magnétiques (15, 16) dont les fentes (18) sont séparées par une distance (A/2) correspondant sensiblement à la moitié de l'écart entre deux conducteurs chauffants.

10. Dispositif selon la revendication 9, caractérisé en ce que les deux capteurs (15,16) de la tête détectrice (14) ont une construction identique.

## Patentansprüche

1. Verfahren zu Prüfung der Heizleiter auf einer mit zwei Sammelschienen (2) und zwischen diesen angeordneten Heizleitern (3) versehenen Glasscheibe, durch Einkoppeln eines Wechselstroms in das Leitersystem und induktive Erfassung des sich um die Heizleiter ausbildenden elektromagnetischen Feldes mit Hilfe von Magnetköpfen (14), von deren Ausgangssignal eine Auswerteschaltung angesteuert wird,
**dadurch gekennzeichnet,** daß der Wechselstrom in das Leitersystem induktiv eingekoppelt wird, und daß der dem von der Induktionsspule erzeugten Streufeld entsprechende Anteil der Ausgangsspannung des Magnetkopfes kompensiert wird, indem durch einen in der Nähe des Magnetkopfes zwischen den Heizleitern angeordneten zweiten Magnetkopf das Streufeld separat erfaßt wird, und daß als die Auswerteschaltung ansteuernde Signalspannung die Differenzspannung der von den beiden Magnetköpfen gelieferten Ausgangsspannungen dient.

2. Verfahren nach Anspruch 1, dadurch gekennzeichnet, daß für die Erfassung des die Heizleiter (3) umgebenden Magnetfeldes und des zwischen den Heizleitern vorhandenen Streufeldes Magnetköpfe mit identischem Aufbau verwendet werden.

3. Verfahren nach Anspruch 1 oder 2, dadurch gekennzeichnet, daß der Meßstrom in eine der beiden Sammelschienen (2) eingekoppelt wird.

4. Verfahren nach Anspruch 3, dadurch gekennzeicnet, daß zur Einkoppelung des Meßstroms eine Induktionsspule mit einer solchen Länge (L) verwendet wird, daß zwei benachbarte Heizleiter von der Induktionsspule überdeckt werden.

5. Verfahren nach Anspruch 3 oder 4, dadurch gekennzeichnet, daß der Meßstrom mit Hilfe einer Induktionsspule (6,7) in der Mitte einer Sammelschiene eingekoppelt wird.

6. Verfahren nach einem der Ansprüche 1 bis 5, dadurch gekennzeichnet, daß eine Induktionsspule mit einem U-förmigen Eisenkern (6) verwendet, und auf der anderen Seite der Glasscheibe den beiden Schenkeln des Eisenkerns gegenüber ein feromagnetisches Joch angeordnet wird.

7. Verfahren nach einem der Ansprüche 1 bis 6, dadurch gekennzeichnet, daß ein Wechselstrom mit einer der Resonanzfrequenz des Gesamtsystems entsprechenden Frequenz verwendet wird.

8. Verfahren nach Anspruch 7, dadurch gekennzeichnet, daß ein Wechselstrom mit einer Frequenz von 3400 bis 4000 Hz verwendet wird.

9. Vorrichtung zur Durchführung des Verfahrens nach Anspruch 1 mit einem eine Induktionsspule (7) und einen Eisenkern (6) umfassenden Induktor und einem Meßkopf (14), der zwei nebeneinander angeordnete Magnetköpfe (15,16) aufweist, deren Luftspalte (18) in einer etwa dem halben Abstand zweier Heizleiter (3) entsprechenden Entfernung (A/2) angeordnet sind.

10. Vorrichtung nach Anspruch 9, dadurch gekennzeichnet, daß die beiden Magnetköpfe (15,16) des Meßkopfes (14) einen identischen Aufbau aufweisen.

## Claims

1. Process for checking heating conductors on a glazing provided with two collectors (2), which connect said heating conductors (3), by creating an alternating current in the network and by the inductive detection of the electro-magnetic field which then forms around them with the aid of measuring heads (14), whose output signal controls an evaluating circuit, characterized in that, inductively coupling the network to the alternating supply, the fraction of the output voltage of the magnetic sensors corresponding to the leakage field of the exciting coil is compensated by a separate measurement of said leakage field performed in the vicinity of the first measurement of the heating conductors, using the difference between the voltages supplied by the two measurements as the control voltage of the evaluating circuit.

2. Process according to claim 1, characterized in that, for collecting the magnetic field produced around the conductors (3) and the leakage field existing between them, use is made of two identical sensors.

3. Process according to one of the claims 1 and 2, characterized in that the current to be measured is produced on one of the two collectors (2).

4. Process according to claim 3, characterized in that for producing the current to be measured use is made of an exciting coil of length (L) such that it covers two adjacent conductors.

5. Process according to one of the claims 3 and 4, characterized in that the current to be measured is produced by means of an inductor (6, 7) placed in the median zone of the collector.

6. Process according to one of the claims 1 to 5, characterized in that use is made of an armature exciting coil comprising a U-shaped core (6) and, facing its two poles, on the rear face of the glazing, a ferromagnetic yoke.

7. Process according to one of the claims 1 to 6, characterized in that use is made of a supply frequency corresponding to the resonant frequency of the complete detection system.

8. Process according to claim 7, characterized in that use is made of a frequency from 3400 to 4000 Hz.

9. Apparatus for performing the process according to claim 1, comprising an inductor having an armature (6) and a winding (7) and a detecting head (14) carrying in juxtaposed manner two magnetic sensors (15, 16), whose slots (18) are separated by a distance (A/2) substantially corresponding to half the spacing between two heating conductors.

10. Apparatus according to claim 9, characterized in that the two sensors (15, 16) of the detecting head (14) have an identical construction.
